# EUROPEAN PATENT APPLICATION

(11) **EP 4 456 678 A1**
(43) Date of publication of application: **30.10.2024**
(21) Application number: 22944830.3
(22) Date of filing: 31.05.2022
(51) Int. Cl.: H05K 3/10

(54) **PATTERN FORMATION METHOD AND PATTERN FORMATION STRUCTURE**

(71) Applicant: Resonac Corporation, Tokyo 105-7325 (JP)
(72) Inventor: IWASHITA, Kenichi, Tokyo 100-6606 (JP); YOSHIHARA, Kensuke, Tokyo 100-6606 (JP); NARITA, Mao, Tokyo 100-6606 (JP); ONO, Keishi, Tokyo 100-6606 (JP); MITSUKURA, Kazuyuki, Tokyo 100-6606 (JP); TOGASAKI, Kei, Tokyo 100-6606 (JP); IMAZU ,Yuki, Tokyo 100-6606 (JP)
(74) Representative: Hoffmann Eitle
(86) International application number: PCT/JP2022/022196
(87) International publication number: WO 2023/233543

(57) **Abstract**

Such a pattern formation method includes a laminating step of laminating a curable resin layer 3 and a support film 4 on a substrate 2, a curing step of curing the entire curable resin layer 3, a peeling step of peeling the support film 4 from the curable resin layer 3 after curing, a processing step of irradiating the curable resin layer 3 after peeling the support film 4 with an excimer laser light 15 via a mask 14 to process the curable resin layer 3 into a predetermined pattern, and a forming step of removing the curable resin layer 3 after forming a plating layer 17 using the curable resin layer 3 with the predetermined pattern as a mask to form a wiring pattern 16 using the plating layer 17 on the substrate 2.

## Description

### Technical Field

The present disclosure relates to a pattern formation method and a pattern formation structure.

### Background Art

Recently, an electronic device has been further downsized, light-weighted, and multi-functionalized. Accordingly, higher integration of LSI, a chip component, or the like has progressed, and the form thereof has also been multi-pinned and downsized. Therefore, there is a demand for higher density and higher accuracy of a semiconductor element, a semiconductor package, a printed-wiring board, a flexible wiring board, and the like, configuring the component described above.

Examples of a pattern formation method of the related art include a semi-additive process. In such a method, an electroless plating layer is formed on an insulating layer, and a resist layer with a predetermined pattern is formed on the electroless plating layer by a photosensitive dry film. After that, an electroplating layer is formed, and the resist layer is peeled and the electroless plating layer is removed to form wiring having a desired pattern on a substrate. However, for the miniaturization of the pattern, there has been a problem that a defect in the pattern due to particles or foreign substances such as attachments, contained in a support film (a PET film) supporting the photosensitive dry film, becomes noticeable.

Regarding such a problem, a method for forming a pattern using laser ablation processing has attracted attention. For example, in a solder resist formation method described in Patent Literature 1, a curable resin in a semi-cured state, including a support film, is formed on a substrate. Next, the support film is irradiated with laser light from above to form a via hole in the curable resin in the semi-cured state. After that, the support film is peeled, and the curable resin layer in the semi-cured state is cured.

### Citation List

### Patent Literature

Patent Literature 1: International Publication WO. 2012/042846

### Summary of Invention

### Technical Problem

However, as in Patent Literature 1 described above, even in a case where the pattern is formed using the laser ablation processing, there remains a possibility that the laser light is refracted by particles, attachments, and the like contained in the support film, which causes a defect in the formed pattern. In addition, in the method of Patent Literature 1 described above, since the support film is irradiated with the laser light from above, a hole is formed in the support film during the laser ablation processing. From the viewpoint of sustainable development goals (SDGs), a method is desirable in which the support film can be reused.

The present disclosure has been made in order to solve the problems described above, and an object thereof is to provide a pattern formation method and a pattern formation structure, in which patterning that has a high accuracy and is based on sustainable development goals is available.

### Solution to Problem

A pattern formation method according to one aspect of the present disclosure includes a laminating step of laminating a curable resin layer and a support film on a substrate, a curing step of curing the entire curable resin layer, a peeling step of peeling the support film from the curable resin layer after curing, a processing step of irradiating the curable resin layer after peeling the support film with excimer laser light via a mask to process the curable resin layer into a predetermined pattern, and a forming step of removing the curable resin after forming a plating layer using the curable resin layer with the predetermined pattern as a mask to form a wiring pattern using the plating layer on the substrate.

In such a pattern formation method, the entire curable resin layer is cured before processing the curable resin layer into the predetermined pattern by the excimer laser light, and the support film is peeled from the curable resin layer after curing. Therefore, when processing the curable resin layer after curing, the refraction of the excimer laser light in the curable resin layer and the refraction of the excimer laser light due to particles, attachments, and the like contained in the support film can be suppressed. Therefore, the occurrence of a defect in the curable resin layer during the processing is suppressed, and the wiring pattern with a high accuracy can be formed on the substrate. In addition, in such a pattern formation method, since the support film is peeled from the curable resin layer before the irradiation of the excimer laser light, it is possible to avoid the formation of a hole in the support film by the excimer laser light. Accordingly, the reuse of the support film used in the step is facilitated, which may contribute to the attainment of patterning based on sustainable development goals.

The support film may be a PET film produced by recycling. In such a pattern formation method, since the entire curable resin layer is cured, the support film is not required to have a high transparent degree regardless of whether the curable resin layer is cured by photocuring or thermal curing. Therefore, by using the PET film produced by recycling as the support film, it is possible to further contribute to the attainment of the patterning based on the sustainable development goals.

A line and space L/S of the wiring pattern may be 5/5 µm or less. In such a pattern formation method, as described above, the occurrence of the defect in the curable resin layer in the processing step is suppressed. Therefore, it is suitable for the formation of a fine wiring pattern with a line and space L/S of 5/5 µm or less.

An aspect ratio of the wiring pattern (a ratio of the height of the wiring pattern to the line width of the wiring pattern) may be 0.5 to 20. In such a pattern formation method, as described above, the occurrence of the defect in the curable resin layer in the processing step is suppressed. Therefore, it is suitable for the formation of a fine wiring pattern with an aspect ratio of 0.5 to 20.

The curable resin layer may be composed of a photocurable resin. In this case, the curing of the entire curable resin layer can be simply implemented by light irradiation.

The curable resin layer may be composed of a thermosetting resin. In this case, the curing of the entire curable resin layer can be simply implemented by heating.

A pattern formation structure according to one aspect of the present disclosure includes a substrate, a curable resin layer laminated on the substrate, and a support film laminated on the curable resin layer, in which the support film is a PET film produced by recycling.

In such a pattern formation structure, the entire curable resin layer can be cured before processing the curable resin layer into a predetermined pattern by excimer laser light, and the support film can be peeled from the curable resin layer after curing. Therefore, when processing the curable resin layer after curing, the refraction of the excimer laser light in the curable resin layer and the refraction of the excimer laser light due to particles, attachments, and the like contained in the support film can be suppressed. Therefore, the occurrence of a defect in the curable resin layer during the processing is suppressed, and a wiring pattern with a high accuracy can be formed on the substrate. In addition, in such a pattern formation structure, the support film is the PET film produced by recycling. By using the PET film produced by recycling as the support film, it is possible to contribute to the attainment of patterning based on sustainable development goals.

### Advantageous Effects of Invention

According to the present disclosure, the patterning that has a high accuracy and is based on the sustainable development goals is available.

### Brief Description of Drawings

[FIG. 1] FIG. 1 is a schematic cross-sectional view illustrating a pattern formation structure according to one embodiment of the present disclosure.
[FIG. 2] FIG. 2 is a flowchart illustrating a pattern formation method according to one embodiment of the present disclosure.
[FIG. 3] FIG. 3 is a schematic cross-sectional view illustrating a laminating step.
[FIG. 4] FIG. 4 is a schematic cross-sectional view illustrating a curing step.
[FIG. 5] FIG. 5 is a schematic cross-sectional view illustrating a peeling step.
[FIG. 6] FIG. 6 is a schematic cross-sectional view illustrating a processing step.
[FIG. 7] FIG. 7 is a schematic cross-sectional view illustrating the subsequent step of FIG. 6.
[FIG. 8] FIG. 8 is a schematic cross-sectional view illustrating a forming step.
[FIG. 9] FIG. 9 is a schematic cross-sectional view illustrating the subsequent step of FIG. 8.

### Description of Embodiments

Hereinafter, a preferred embodiment of a pattern formation method and a pattern formation structure according to one aspect of the present disclosure will be described in detail with reference to the drawings.

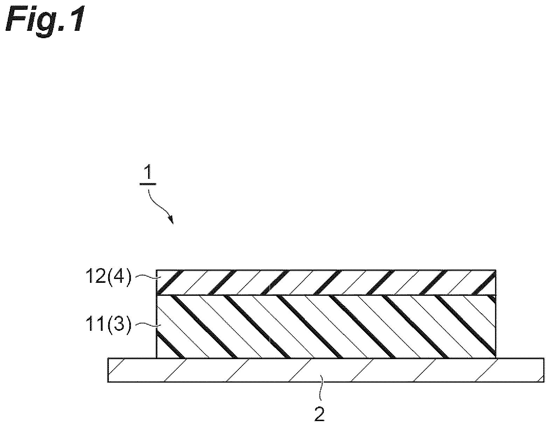

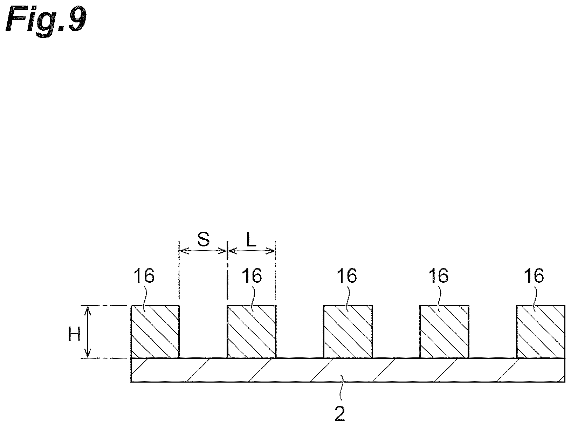

FIG. 1 is a schematic cross-sectional view illustrating a pattern formation structure according to one embodiment of the present disclosure. As illustrated in FIG. 1, a pattern formation structure 1 includes a substrate 2, a curable resin layer 3 laminated on the substrate 2, and a support film 4 laminated on the curable resin layer 3. The substrate 2 is a member to be a target for forming a wiring pattern 16 (refer to FIG. 9). In addition, the substrate 2 is an adherend of the curable resin layer 3. Examples of the substrate 2 include a silicon wafer, a silicon wafer with a film on which a metal such as Cu is deposited, and a copper clad laminate.

The curable resin layer 3, for example, is composed of a photocurable resin or a thermosetting resin. Here, the curable resin layer 3 is composed of a negative photocurable resin 11. As the photocurable resin 11, a film-shaped photocurable resin may be used, or a liquid photocurable resin may be used by application. The liquid photocurable resin 11 is produced by stirring each material. A stirring (dispersion) method is not particularly limited, but stirring may be performed by applying heat or the like, or stirring may be performed in an inert gas atmosphere, a depressurized atmosphere, or a pressurized atmosphere. By filtering the stirred resin composition, it is possible to remove foreign substances. The film-shaped photocurable resin 11, for example, is provided in a state where a solution of a photocurable resin composition is homogeneously applied to the support film and dried.

In order to attain a high etching rate during laser ablation processing described below, the photocurable resin 11 is designed in consideration of 1) the ease of the breakage of a molecular bond during laser light irradiation, and 2) absorbency with respect to the wavelength of the laser light. In order to satisfy 1), a compound with lower molecular bond energy is selected. In order to satisfy 2), a component absorbing the wavelength of the laser light is contained. The photocurable resin 11 contains a polymerizable compound as a component (A), and contains an ultraviolet absorber as a component (B). The component (A) and the component (B) may be mostly contained, or may be mixed with other components.

The polymerizable compound is selected on the assumption that the photocurable resin 11 is used by being laminated on the substrate 2, and then, polymerized. By laminating, and then, polymerizing the photocurable resin, it is possible to ensure laminability or applicability before laminating and suppress tackiness after polymerizing. As the polymerizable compound, for example, a compound having a polymerizable ethylenically unsaturated bond in the molecules is used. Examples of the component (A) include a (meth)acrylic resin, urethane acrylate, and epoxy acrylate. The component (A) may be a non-aromatic photopolymerizable compound from the viewpoint of low molecular bond energy. Even in a case where the component (A) is mixed with an aromatic compound, or a case where a part of the component (A) has an aromatic functional group, by adjusting the ratio, it is possible to attain a high etching rate during the laser ablation processing.

The ultraviolet absorber is not particularly limited insofar as the ultraviolet absorber is a component absorbing light at a desired wavelength. As the ultraviolet absorber, for example, a known absorber capable of absorbing laser light of ArF (wavelength: 193 nm), KrF (wavelength: 248 nm), XeCl (wavelength: 308 nm), or XeF (wavelength: 351 nm) can be used. Examples of such an absorber include a benzotriazole-based absorber, a triazine-based absorber, a salicylic acid derivative-based absorber, and a benzophenone-based absorber.

The ultraviolet absorber may have a polymerizable unsaturated group. The ultraviolet absorber is divided into a type in which radicals are generated by the absorption of an ultraviolet ray and a type in which radicals are not generated by the absorption of an ultraviolet ray. The ultraviolet absorber with the type of generating the radicals contains a photopolymerization initiator. By containing the photopolymerization initiator, it is possible to cure the photocurable resin 11 with the ultraviolet ray before and after the laser ablation processing, and improve the handleability of the pattern formation structure 1.

Examples of the photopolymerization initiator include aromatic ketone such as 2-benzyl-2-dimethyl amino-1-(4-morpholinophenyl)-butanon-1 and 2-methyl-1-[4-(methyl thio)phenyl-2-morpholino-propanon-1, quinones such as alkyl anthraquinone, a benzoin ether compound such as benzoin alkyl ether, a benzoin compound such as benzoin and alkyl benzoin, a benzyl derivative such as benzyl dimethyl ketal, a 2,4,5-triaryl imidazole dimer such as a 2-(o-chlorophenyl)-4,5-diphenyl imidazole dimer and a 2-(o-fluorophenyl)-4,5-diphenyl imidazole dimer, and an acridine derivative such as 9-phenyl acridine and 1,7-bis(9,9'-acridinyl) heptane. Among the photopolymerization initiators, only one type may be used alone, or two more types may be used in combination.

In the case of using the film-shaped photocurable resin 11, the photocurable resin 11 may contain a binder polymer from the viewpoint of film formability. It is preferable that the binder polymer is a material having compatibility with the component (A) and the component (B) from the viewpoint of storage stability. The binder polymer may be a component more flexible than the polymerizable compound of the component (A). Accordingly, it is possible to ensure the flexibility of the curable resin layer 3 after curing. As the binder polymer, for example, a (meth)acrylic resin, a urethane-based resin, an epoxy resin, an amide resin, an amide epoxy resin, an alkyd resin, a polyimide resin, and the like are used. Among such resins, it is preferable to use the (meth)acrylic resin from the viewpoint of contributing to the rate of the laser ablation processing, that is, from the viewpoint of low molecular bond energy.

As the binder polymer, it is preferable to select resins having a non-aromatic basic skeleton from the viewpoint of low molecular bond energy. Here, the non-aromatic basic skeleton indicates that the basic skeleton repeated a plurality of times by polymerization does not contain aromatic series, and does not indicate aromatic series disposed only on the terminal or the like. An aromatic binder polymer and an aliphatic polymer may be mixed to attain a balance with the etching rate.

The molecular weight of the binder polymer is different in accordance with the state of the photocurable resin 11. In the case of using the film-shaped photocurable resin 11, for example, the molecular weight may be selected to attain a balance between the film formability of the film and the rate of the laser ablation processing. By sufficiently ensuring the molecular weight, it is possible to ensure the film formability and suppress dripping or the like during film formation and storage. By not making the molecular weight excessive, it is possible to suppress a decrease in the rate of the laser ablation processing. In the case of using the liquid photocurable resin 11, by designing a low molecular weight in an applicable range, it is possible to increase the rate of the laser ablation processing.

The photocurable resin 11 may contain a thermal curing accelerator. The thermal curing accelerator is not particularly limited insofar as the photocurable resin composition can be thermally cured, and can be suitably selected from thermal curing accelerators usually used. By adding the thermal curing accelerator, it is possible to cure the photocurable resin 11 at a lower temperature, and improve the handleability of the pattern formation structure 1. Examples of the thermal curing accelerator include imidazoles, a dicyandiamide derivative, dicarboxylic acid dihydrazide, triphenylphosphine, tetraphenyl phosphonium tetraphenylborate, and 2-ethyl-4-methyl imidazole-tetraphenylborate, 1,8-diazabicyclo[5,4,0]undecene-7-tetraphenylborate. Among the thermal curing accelerators, only one type may be used alone, or two more types may be used in combination.

The photocurable resin 11 may contain a polymerization inhibitor. By the photocurable resin 11 containing the polymerization inhibitor, the shelf life and the work life of the photocurable resin composition are extended. In addition, it is possible to suppress unnecessary polymerization during the laser ablation processing. Here, the unnecessary polymerization indicates that radicals are generated from the photopolymerization initiator by the laser light during the laser ablation processing, and the polymerization progresses. As the polymerization inhibitor, a material having a polymerization inhibition effect with respect to radical polymerization is used. Examples of the polymerization inhibitor include catechols such as t-butylcatechol, hydroquinones such as hydroquinone, methylhydroquinone, t-butylhydroquinone, and p-methoxyphenol, alkoxyquinones such as Methoquinone, benzoquinones such as p-benzoquinone, methyl-p-benzoquinone, and t-butyl-p-benzoquinone.

The photocurable resin 11 may contain a solvent. In the case of using the liquid photocurable resin 11, it is preferable that the photocurable resin 11 contains the solvent from the viewpoint of the easiness of viscosity adjustment and from the viewpoint of the easiness of production and inspection. In the case of using the film-shaped photocurable resin 11, it is preferable that the solvent has a low content. The solvent that is not completely removed in the step of applying, drying, or the like may remain in the photocurable resin 11.

The photocurable resin 11, as necessary, may contain a dye such as Malachite Green, Victoria Pure Blue, Brilliant Green, and Methyl Violet, a photochromic agent such as Leucocrystal Violet, diphenylamine, benzylamine, triphenylamine, diethylaniline, and o-chloroaniline, a thermal development inhibitor, a plasticizer such as p-toluenesulfonamide, a pigment, a filler, an antifoaming agent, a flame retardant, a stabilizer, a tackifier, a leveling agent, a peeling accelerator, an antioxidant, a fragrance, an imaging agent, a thermal cross-linking agent, and the like. It is possible to contain approximately 0.01 to 20 parts by mass of each component, for example, with respect to the total solid content of 100 parts by mass of the component (A) and the component (B). Among such materials, only one type may be used alone, or two more types may be used in combination.

The support film 4, for example, is composed of a polymer film having heat resistance and solvent resistance, such as polyolefin such as polypropylene and polyethylene, and polyester such as polyethylene terephthalate. Among such films, it is preferable to use a polyethylene terephthalate (PET) film from the viewpoint of transparency. The PET film contains particles for improving fluidity and releasability when molding the PET film. As the particles, for example, inorganic particles such as calcium carbonate, calcium phosphate, silica, kaolin, talc, titanium dioxide, alumina, barium sulfate, calcium fluoride, lithium fluoride, zeolite, and molybdenum sulfide, organic particles such as an ion exchange resin, a cross-linking polymer, and calcium oxalate, precipitated particles produced when polymerizing polyester, and the like can be used.

In this embodiment, the support film 4 is a PET film 12 produced by recycling. It is possible to contain, for example, approximately 1 to 10 parts by mass of the particles of the PET film 12 produced by recycling with respect to 100 parts by mass of the PET film. The transparent degree of the PET film 12 produced by recycling, for example, is less than 1.5. The transparent degree, for example, can be measured by an integrating sphere-type turbidimeter.

Next, a pattern formation method using the pattern formation structure 1 described above will be described in detail.

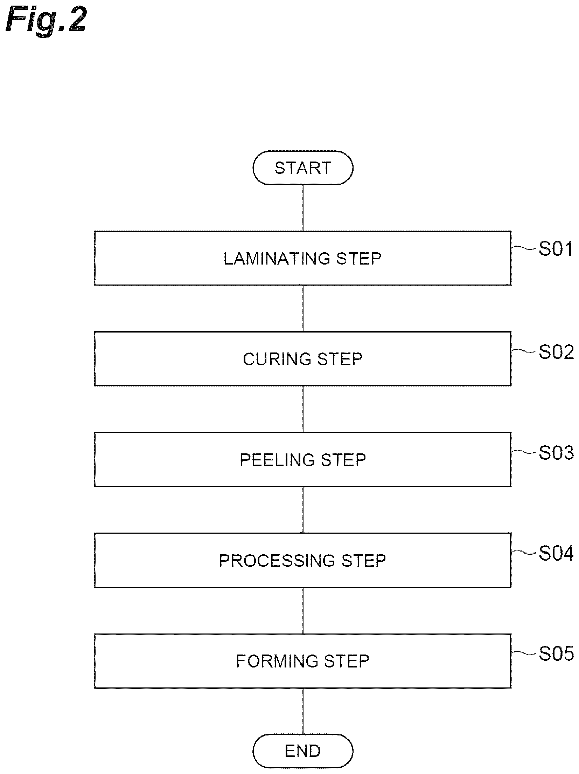

FIG. 2 is a flowchart illustrating a pattern formation method according to one embodiment of the present disclosure. As illustrated in FIG. 2, such a pattern formation method includes a laminating step (step S01), a curing step (step S02), a peeling step (step S03), a processing step (step S04), and a forming step (step S05).

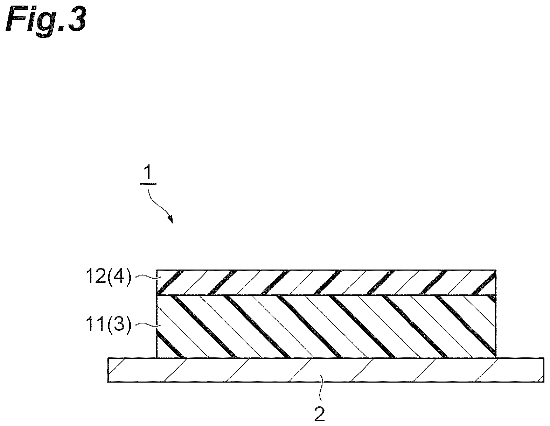

The laminating step S01, as illustrated in FIG. 3, is a step of laminating the curable resin layer 3 and the support film 4 on the substrate 2. A laminating method with respect to the substrate 2 is different in accordance with whether the photocurable resin 11 is in the shape of a liquid or a film. In a case where the photocurable resin 11 is in the shape of a liquid, the photocurable resin 11 can be laminated by applying the photocurable resin composition to the substrate 2 and drying the photocurable resin composition. Examples of an application method for the photocurable resin composition include a spray method, a roll coating method, a spin coating method, a slit die application method, a bar application method, an ink jet method, a screen printing method, a gravure coating method, a curtain coating method, and a knife coating method.

It is preferable that the film thickness of the photocurable resin 11 before drying is greater than a target value in consideration of a decrease in the film thickness due to the volatilization of the solvent and the flow of the photocurable resin composition during drying. In the case of further decreasing the film thickness of the photocurable resin 11 after drying, the photocurable resin composition may contain a large amount of solvent such that a film thickness decrease rate during drying is increased by the volatilization of the solvent. A solvent residual rate after drying may be 10% by mass or less, may be 5% by mass or less, or may be 2% by mass or less.

The film thickness of the photocurable resin 11 after drying, for example, is 1 to 200 µm. The film thickness of the photocurable resin 11 after drying may be 5 to 100 µm, or may be 10 to 50 µm. By setting the film thickness to 1 µm or more, it becomes easy to industrially attain the application. By setting the film thickness to 200 µm or less, it is possible to suppress the occurrence of the insufficient volatilization of the solvent or abnormal appearance. In a case where the film thickness is 100 µm or more, a method for applying the photocurable resin composition with a film thickness of 100 µm or less, and then, laminating two or more photocurable resin composition layers can also be adopted.

The photocurable resin 11 formed by the application or the like may be heated at 50 to 250°C. A heating temperature may be 50 to 200°C. The heating may be implemented in an inert atmosphere such as nitrogen, or may be implemented in a depressurized condition. A drying time is not particularly limited. A drying history may include a temperature increase and a temperature decrease, or may be a constant temperature. In a case where drying including a temperature increase and a temperature decrease is implemented, the surface of the photocurable resin 11 after drying tends to be flatter.

In a case where the photocurable resin 11 is in the shape of a film, by compression-bonding the photocurable resin 11 onto the substrate 2 while heating, it is possible to laminate the photocurable resin 11. From the viewpoint of adhesion and followability with respect to the substrate 2, the compression bonding of the photocurable resin 11 may be implemented under reduced pressure. A heating temperature, for example, may be room temperature to 130°C. A pressure during the compression bonding, for example, may be approximately 0.01 to 1.0 MPa (approximately 0.1 to 10 kgf/cm²). In order to further improve laminability, a preheating treatment of the substrate 2 and a heating treatment after laminating may be implemented.

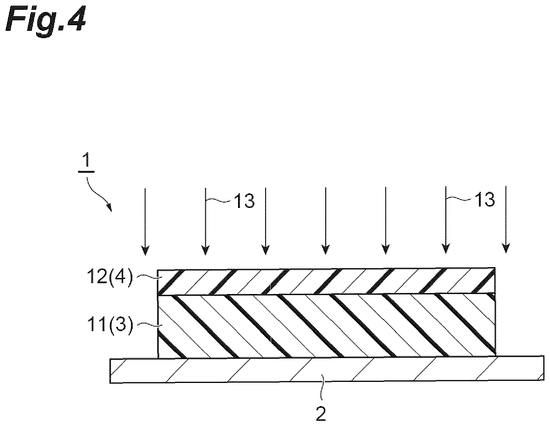

The curing step S02 is a step of curing the entire curable resin layer 3. In the curing step S02, as illustrated in FIG. 4, the entire surface of the photocurable resin 11 is irradiated with light 13 via the support film 4 to cure the entire photocurable resin 11. The light 13, for example, is ultraviolet light. As a light source for the light 13, for example, an ultraviolet lamp can be used. The irradiation intensity of the light 13, for example, is 1 to 100 mW. The irradiation time of the light 13, for example, is 1 to 1000 seconds.

Here, the curing indicates completely or approximately completely curing the curable resin layer 3. A curing rate F of the curable resin layer 3 after implementing the curing step, for example, is 50% to 100%. The curing rate F may be 85% or more, or may be 90% or more. In a case where the curing time of the curable resin composition in a solution state is set to T1, and the curing time of the curable resin composition after the curing step is set to T2, the curing rate F is calculated by F = ((T1 - T2)/T1) × 100. The curing time, for example, is measured on the basis of Item 5.7 "Curing Time Test" in JIS C 6521.

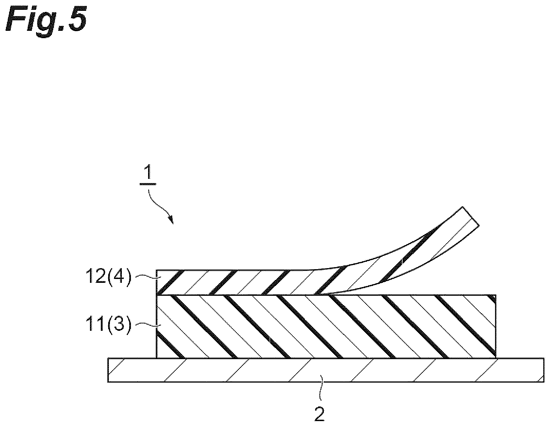

As illustrated in FIG. 5, the peeling step S03 is a step of peeling the support film 4 from the curable resin layer 3 after curing. The peeling of the support film 4 from the curable resin layer 3, for example, is implemented by an automatic peeler. The peeled support film 4 can be reused to form a wiring pattern for another substrate. In the case of using the film-shaped photocurable resin 11 in the laminating step, the peeled support film 4 may be reused as the support film of the photocurable resin 11.

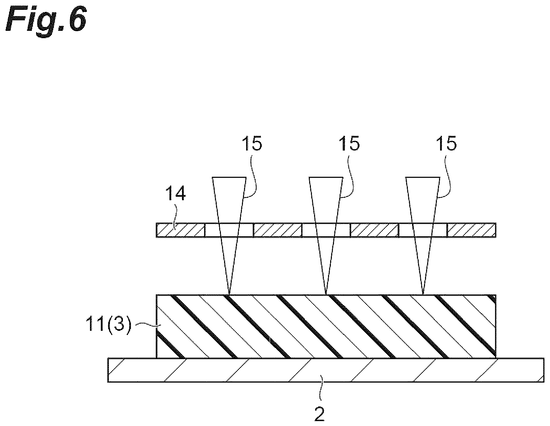

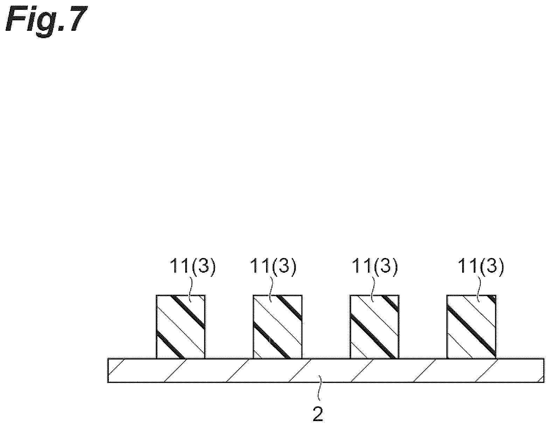

The processing step S04 is a step of processing the curable resin layer 3 into a predetermined pattern. In the processing step, as illustrated in FIG. 6, the curable resin layer 3 after peeling the support film 4 is irradiated with excimer laser light 15 via a mask 14 to process the curable resin layer 3 into the predetermined pattern. That is, in the processing step, the laser ablation processing with respect to the curable resin layer 3 after curing is implemented using the excimer laser light 15. Here, as illustrated in FIG. 7, the curable resin layer 3 after peeling the support film 4 is processed into the shape of a line, and a mask when forming a plating layer in the subsequent forming step S05 is formed on the substrate 2.

Examples of a light source for the excimer laser light 15 include F2 excimer laser (wavelength: 157 nm), ArF excimer laser (wavelength: 193 nm), KrF excimer laser (wavelength: 248 nm), XeCl excimer laser (wavelength: 308 nm), and XeF excimer laser (wavelength: 351 nm). In general, as the energy density of the excimer laser light 15 per 1 shot on the surface of the curable resin layer 3 increases, the rate of the laser ablation processing increases. However, in a case where the energy density is a certain level or more, the rate of the laser ablation processing is saturated. The energy density of the excimer laser light 15 per 1 shot on the surface of the curable resin layer 3 also depends on a processing area or the cost of a processing machine, and in consideration of the circumstances described above, for example, may be 10 to 2000 mJ/cm², or may be 100 to 1500 mJ/cm².

As the optical system of the excimer laser light 15, a light collection optical system or imaging optics can be used. In the case of processing the curable resin layer 3 into the predetermined pattern, it is preferable to use the imaging optics from the viewpoint of a throughput. The reduced projection magnification of the imaging optics, for example, may be 1 to 300 times, or may be 1 to 20 times.

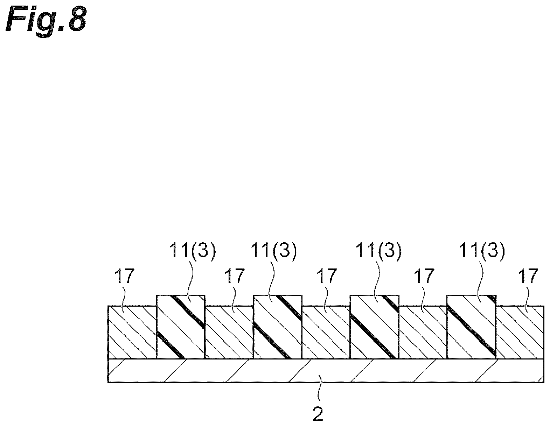

The forming step S05 is a step of forming the wiring pattern 16 on the substrate. In the forming step, as illustrated in FIG. 8, a plating layer 17 is formed using the curable resin layer 3 with the predetermined pattern as a mask. Examples of the constitution material of the plating layer 17 include Cu, Ni, and Sn. As a formation method for the plating layer 17, for example, electroplating can be used. In the formation of the plating layer 17, a desmear treatment may be implemented in advance on the surface of the substrate 2, and a seed layer for forming the plating layer 17 may be provided on the surface.

After the formation of the plating layer 17, as illustrated in FIG. 9, the curable resin layer 3 is removed to form the wiring pattern 16 using the plating layer 17 on the substrate 2. In a case where the seed layer is formed on the surface of the substrate 2, the seed layer is removed by etching or the like after removing the curable resin layer 3 to electrically separate the wiring patterns 16 and 16 from each other. Examples of a removal method for the curable resin layer 3 include a wet peeling method using an inorganic alkaline aqueous solution or an organic alkaline aqueous solution, and an organic solvent, and a dry etching method using a plasma treatment.

As a base for the alkaline aqueous solution used for the wet peeling method, for example, alkali hydroxide such as a hydroxide of lithium, sodium, or potassium, alkali carbonate such as carbonate or a bicarbonate of lithium, sodium, potassium, or ammonium, an alkali metal phosphate such as potassium phosphate or sodium phosphate, an alkali metal pyrophosphate such as sodium pyrophosphate or potassium pyrophosphate, borax (sodium tetraborate), sodium metasilicate, tetramethyl ammonium hydroxide, ethanol amine, ethylene diamine, diethylene triamine, 2-amino-2-hydroxymethyl-1,3-propanediol, 1,3-diamino-2-propanol, morpholine, and the like are used. Examples of the wet peeling method include a method using dipping, paddling, spraying, brushing, slapping, scrubbing, or oscillation immersing.

In this embodiment, a line and space L/S of the wiring pattern 16 obtained after the forming step is 5/5 µm or less. That is, in this embodiment, a line width L of the wiring pattern 16 is 5 µm or less, and a gap S between the adjacent wiring patterns 16 and 16 is 5 µm or less. In addition, in this embodiment, the aspect ratio of the wiring pattern 16 (a ratio of a height H of the wiring pattern 16 to the line width L of the wiring pattern 16) is 0.5 to 20. The aspect ratio of the wiring pattern 16 may be 1 to 10.

As described above, in such a pattern formation method, the entire curable resin layer 3 is cured before processing the curable resin layer 3 into the predetermined pattern by the excimer laser light 15, and the support film 4 is peeled from the curable resin layer 3 after curing. Therefore, when processing the curable resin layer 3 after curing, the refraction of the excimer laser light 15 in the curable resin layer 3 and the refraction of the excimer laser light 15 due to particles, attachment, and the like contained in the support film 4 can be suppressed. Therefore, the occurrence of a defect in the curable resin layer 3 during the processing is suppressed, and the wiring pattern 16 with a high accuracy can be formed on the substrate 2. In addition, in such a pattern formation method, since the support film 4 is peeled from the curable resin layer 3 before the irradiation of the excimer laser light 15, it is possible to avoid the formation of a hole in the support film 4 by the excimer laser light 15. Accordingly, the reuse of the support film 4 used in the step is facilitated, which may contribute to the attainment of patterning based on sustainable development goals.

In this embodiment, the support film 4 is the PET film 12 produced by recycling. In such a pattern formation method, since the entire curable resin layer 3 is cured, the support film 4 is not required to have a high transparent degree regardless of whether the curable resin layer 3 is cured by photocuring or thermal curing. Therefore, by using the PET film 12 produced by recycling as the support film 4, it is possible to further contribute to the attainment of the patterning based on the sustainable development goals.

In this embodiment, the line and space L/S of the wiring pattern 16 is 5/5 µm or less. In such a pattern formation method, as described above, the occurrence of the defect in the curable resin layer 3 in the processing step is suppressed. Therefore, it is suitable for the formation of the fine wiring pattern 16 with a line and space L/S of 5/5 µm or less.

In this embodiment, the aspect ratio of the wiring pattern 16 is 0.5 to 20. In such a pattern formation method, as described above, the occurrence of the defect in the curable resin layer in the processing step is suppressed. Therefore, it is suitable for the formation of the fine wiring pattern 16 with an aspect ratio of 0.5 to 20.

In this embodiment, the curable resin layer 3 is composed of the photocurable resin 11. Accordingly, the curing of the entire curable resin layer 3 can be simply implemented by light irradiation.

In addition, in the pattern formation structure 1, the entire curable resin layer 3 can be cured before processing the curable resin layer 3 into the predetermined pattern by the excimer laser light 15, and the support film 4 can be peeled from the curable resin layer 3 after curing. Therefore, when processing the curable resin layer 3 after curing, the refraction of the excimer laser light 15 in the curable resin layer 3 and the refraction of the excimer laser light 15 due to the particles, the attachments, and the like contained in the support film 4 can be suppressed. Therefore, the occurrence of the defect in the curable resin layer 3 during the processing is suppressed, and the wiring pattern 16 with a high accuracy can be formed on the substrate. In addition, in the pattern formation structure 1, the support film 4 is the PET film 12 produced by recycling. By using the PET film 12 produced by recycling as the support film 4, it is possible to contribute to the attainment of the patterning based on the sustainable development goals.

The present disclosure is not limited to the embodiment described above. For example, in the embodiment described above, the support film 4 is the PET film 12 produced by recycling, but the support film 4 may be a PET film before being produced by recycling. When implementing the pattern formation method at first time, the PET film before being produced by recycling may be used, and when implementing the pattern formation method after the second time, the PET film 12 produced by recycling the PET film may be used.

The curable resin layer 3 may be composed of the thermosetting resin. In this case, the curing of the entire curable resin layer 3 can be simply implemented by heating. As the thermosetting resin, for example, a phenol resin, an epoxy resin, a melamine resin, an alkyd resin, a silicone resin, thermosetting polyimide, and the like can be used. In the case of using the thermosetting resin, a curing condition in the curing step S02, for example, can be a temperature of 120°C or higher for 30 minutes or longer in an oven.

### Reference Signs List

1: pattern formation structure, 2: substrate, 3: curable resin layer, 4: support film, 11: photocurable resin, 12: PET film produced by recycling, 14: mask, 15: excimer laser light, 16: wiring pattern, 17: plating layer.

## Claims

1. A pattern formation method, comprising:
a laminating step of laminating a curable resin layer and a support film on a substrate;
a curing step of curing the entire curable resin layer;
a peeling step of peeling the support film from the curable resin layer after curing;
a processing step of irradiating the curable resin layer after peeling the support film with excimer laser light via a mask to process the curable resin layer into a predetermined pattern; and
a forming step of removing the curable resin after forming a plating layer using the curable resin layer with the predetermined pattern as a mask to form a wiring pattern using the plating layer on the substrate.

2. The pattern formation method according to claim 1,
wherein the support film is a PET film produced by recycling.

3. The pattern formation method according to claim 1 or 2,
wherein a line and space L/S of the wiring pattern is 5/5 µm or less.

4. The pattern formation method according to any one of claims 1 to 3,
wherein an aspect ratio of the wiring pattern is 0.5 to 20.

5. The pattern formation method according to any one of claims 1 to 4,
wherein the curable resin layer is composed of a photocurable resin.

6. The pattern formation method according to any one of claims 1 to 4,
wherein the curable resin layer is composed of a thermosetting resin.

7. A pattern formation structure, comprising:
a substrate;
a curable resin layer laminated on the substrate; and
a support film laminated on the curable resin layer,
wherein the support film is a PET film produced by recycling.
